# EUROPÄISCHE PATENTSCHRIFT

(11) **EP 1 788 113 B1**
(45) Veröffentlichungstag und Bekanntmachung des Hinweises auf die Patenterteilung: **11.05.2011**
(21) Anmeldenummer: 05023355.0
(22) Anmeldetag: 26.10.2005
(51) Int. Cl.: C23C 14/04, C23C 14/56, H01G 13/00, C23C 14/24

(54) **Verdampfervorrichtung mit einem Behälter für die Aufnahme von zu verdampfendem Material**
Evaporator with a container for receiving the evaporation material
Evaporateur avec un réservoir pour recevoir le matériau à évaporer

(43) Veröffentlichungstag der Anmeldung: 23.05.2007
(73) Patentinhaber: Applied Materials GmbH & Co. KG, 63755 Alzenau (DE)
(72) Erfinder: Wenk, Heinrich, 61231 Bad Nauheim (DE)
(74) Vertreter: Schickedanz, Willi

(56) Entgegenhaltungen:
- EP-A- 0 494 340
- EP-A- 1 493 836
- EP-A1- 1 493 836
- DE-A1- 3 922 187
- DE-A1- 19 843 818
- DE-A1- 19 848 177
- PATENT ABSTRACTS OF JAPAN Bd. 2003, Nr. 12, 5. Dezember 2003 (2003-12-05) -& JP 2004 214185 A (SONY CORP), 29. Juli 2004 (2004-07-29)

## Beschreibung

Die Erfindung betrifft eine Verdampfervorrichtung nach dem Oberbegriff des Patentanspruchs 1.

Ölverdampfer werden beispielsweise für die Herstellung von Kondensatoren benötigt. Hierbei werden Dielektrika, z. B. Kunststofffolien, mit einer Metallschicht versehen. Um negative Folgen für den Kondensator bei elektrischen Überschlägen zu vermeiden, werden auf der Kunststofffolie metallfreie Streifen vorgesehen. Diese metallfreien Streifen werden dadurch erzeugt, dass an bestimmten Stellen ein Ölfilm auf die Kunststofffolie aufgebracht wird. Der anschließend auf die Kunststofffolie aufgebrachte Metalldampf, vorzugsweise Aluminium, kann sich an denjenigen Stellen nicht festsetzen, wo sich der Ölfilm befindet.

Eine Verdampfervorrichtung mit einer Düse ist aus JP 10008241 bekannt. Dort wird das zu verdampfende Material in einem Tiegel verdampft, wobei es Ober eine Düse austritt und in Richtung des Substrats wandert, wo es schließlich kondensiert. Dabei kann mittels eines Ventils die Menge an austretendem Dampf gesteuert werden. Diese Vorrichtung wird aber lediglich für das Verdampfen von Metallen eingesetzt.

Weiterhin ist eine Vorrichtung zum Herstellen von metallfreien Streifen bei im Vakuum beschichteten Folienbahnen, insbesondere für Kondensatoren bekannt, die einen rohrförmigen Behälter für die Aufnahme eines Trennmittels, beispielsweise von Öl, aufweist (DE 39 22 187 A1). In dem rohrförmigen Behälter, der durch kreisscheibenförmige Endteile verschlossen ist, befindet sich ein Heizstab, der vollständig von Öl umspült ist. Außerdem befindet sich in dem Behälter ein Dampfaustrittsrohr, das mit seinem einen Ende über den Ölpegel hinausragt und an seinem anderen Ende eine Austrittsdüse aufweist. Die Austrittsdüse liegt hierbei unterhalb des Ölreservoirs.

Des Weiteren ist eine Vorrichtung zum Verdampfen von Öl bekannt, wobei sich das Öl in einem rohrähnlichen Gefäß befindet (JP 2001 279425). Dieses Gefäß besitzt mehrere in einer Reihe angeordnete Öffnungen, aus denen der Dampf austreten kann.

In einer anderen Vorrichtung befindet sich das Öl in einer länglichen Wanne (JP 2004-214185). Diese Wanne besitzt mehrere Öffnungen, die in einer Reihe angeordnet sind und die Form einer Düsenleiste annehmen. Mittels dieser Düsenleiste ist es möglich, sehr große Flächen zu beschichten.

Bekannt ist eine Verdampfervorrichtung, bestehend aus einem Behälter sowie einer Absperrvorrichtung und einem Düsenkörper (DE 198 48 177 A1). Dabei sind der Behälter mit der Absperrvorrichtung und die Absperrvorrichtung mit dem Düsenkörper über eine Zuleitung miteinander verbunden.

Ein Verfahren zum bereichsweisen Auftragen von Trennmitteln mittels eines Verdampfers auf bewegte Substrate ist ebenfalls bekannt (EP 1 493 836 A1). Dieser Verdampfer weist zwei übereinander liegende Kammern auf, die über einen Kanal miteinander verbunden sind. Dabei befindet sich das zu verdampfende Material in der unteren Kammer und kann über den Kanal in die darüber liegende Kammer gelangen. Mittels eines spannungsgesteuerten Proportionalventils kann die in die obere Kammer strömende Dampfmenge pro Zeiteinheit gesteuert werden, Die Verdampfervorrichtung weist dabei ebenfalls einen Behälter auf. Der Behälter hat jedoch auf seiner Oberseite keine Bohrungen, sondern ein Stellventil. Außerdem ist kein um eine Achse drehbarer Körper offenbart.

Schließlich ist eine weitere Verdamlpfereinrichtung mit einem Behälter für die Aufnahme von zu verdampfendem Material bekannt (US 2006/0162662 A1). Es sind hierbei jedoch keine zwei Platten vorgesehen, die einen Schlitz zwischen sich bilden. Desgleichen ist auch kein Zwischenraum zwischen den beiden Platten und einer Ventilplatte vorgesehen.

Aufgabe der vorliegenden Erfindung ist es, eine Verdampfervorrichtung für das Verdampfen von Öl bereitzustellen, die an der Düse eine Absperrvorrichtung aufweist.

Die Aufgabe wird gemäß den Merkmalen des Anspruchs 1 gelöst.

Die Erfindung betrifft somit eine Verdampfervorrichtung mit einem Behälter für die Aufnahme von zu verdampfendem Material. Mit dieser Verdampfervorrichtung kann ein Ölfilm auf bestimmte Stellen einer zu beschichtenden Folie aufgebracht werden, wobei diese Folie in einem weiteren Schritt mit Aluminium oder Zink beschichtet wird. Dort, wo sich der Ölfilm befindet, schlägt sich kein Aluminium oder Zink nieder. Mit Hilfe eines Stabventils wird eine präzise Auftragung des Öls auf die Folie gewährleistet. Dieses Stabventil wird von einem Schrittmotor angetrieben, der in prozentualen Anteilen Öldampf freigeben kann.

Mit dieser Verdampfervorrichtung können Substrate, vorzugsweise metallisierte Kunststofffolien, mit einem festen oder flüssigen Gemisch gesättigter oder ungesättigter Kohlenwasserstoffe beschichtet werden. Es ist aber auch der Einsatz von vollsynthetischen Ölen möglich. Dabei kann eine Kunststofffolie, wie in JP 2004-214185 gezeigt, mittels Rollen über die hier beschriebene Verdampfervorrichtung geführt werden.

Die sich auf der Kunststofffolie befindliche Metallschicht oder Schichten werden mit dieser Verdampfervorrichtung gleichmäßig beschichtet, da es möglich ist, den Öldampf zu dosieren. Eine anschließende Beschichtung der Ölschicht mit weiteren Materialien ist mit dieser Verdampfervorrichtung ebenfalls kein Problem.

Dadurch, dass unterhalb der Austrittsdüse eine Absperrvorrichtung angebracht ist, kann die Menge an ausströmendem Öldampf geregelt werden. Es wird gewährleistet, dass nicht ständig Öldampf aus der Anlage tritt, zumal die Absperrvorrichtung auch vollständig geschlossen werden kann. Damit ist ein Austreten von Öldampf nicht mehr möglich. Dies hat insbesondere den Vorteil, dass der Heizvorgang nicht unterbrochen werden muss, wenn für kurze Zeit kein Substrat über die Verdampfervorrichtung bewegt wird.

Ein weiterer Vorteil liegt darin, dass die Verschmutzung durch austretenden Öldampf auf ein Minimum reduziert wird.

Der Verlust an Öl durch ständiges Verdampfen wird damit erheblich verringert.

Ein Ausführungsbeispiel der Erfindung ist in den Zeichnungen dargestellt und wird nachfolgend näher beschrieben. Es zeigen:
Fig. 1 eine perspektivische Explosionsdarstellung einer Verdampfervorrichtung;
Fig. 2 einen Querschnitt durch die Verdampfervorrichtung gemäß Fig. 1;
Fig. 3 einen Längsschnitt durch einen Teil der Verdampfervorrichtung gemäß Fig. 1;
Fig. 4 eine Draufsicht auf die Verdampfervorrichtung gemäß Fig. 1.

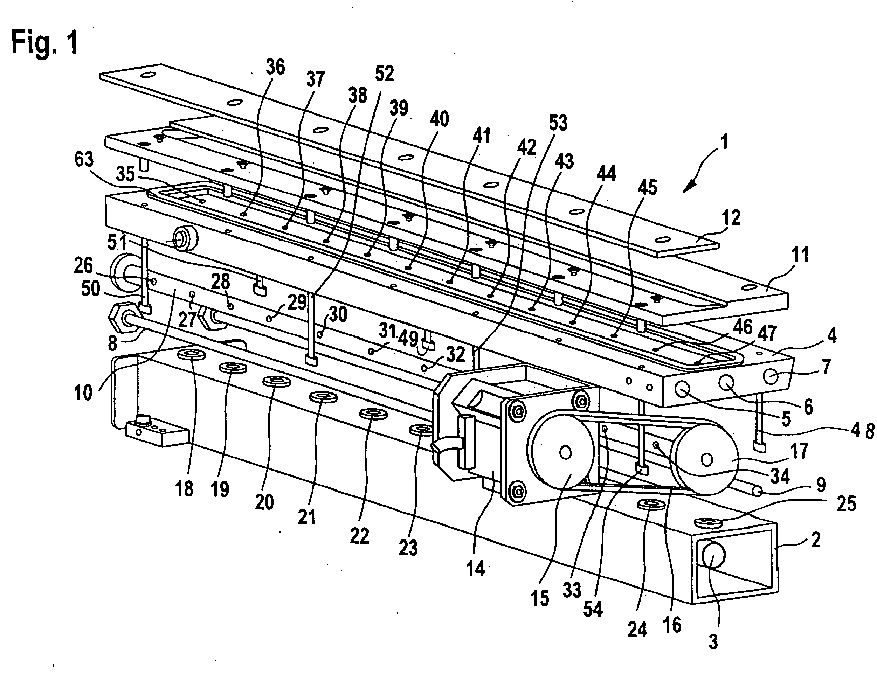

Die Fig. 1 zeigt eine Explosionsdarstellung einer erfindungsgemäßen Verdampfervorrichtung 1. Diese Verdampfervorrichtung 1 weist einen Ölbehälter 2 auf, in dem sich ein Heizstab 3 befindet. Oberhalb des Ölbehälters 2 ist eine Ventilplatte 4 vorgesehen, die drei Längsbohrungen 5, 6, 7 aufweist. In den Längsbohrungen 5 und 7 befinden sich Heizstäbe 8, 9, während sich in der Längsbohrung 6 ein Stabventil 10 befindet. Die Heizstäbe 8, 9 bzw. das Stabventil 10 sind in der Fig. 1 außerhalb der Ventilplatte 4 dargestellt. Oberhalb der Ventilplatte 4 befindet sich eine Düsenplatte 11, auf der eine Feineinstellungsplatte 12 ruht. Mit 14 ist ein Schrittmotor bezeichnet, der ein erstes Rad 15 antreibt, welches über ein Kopplungselement 16, beispielsweise eine Kette oder einen Keilriemen, ein zweites Rad 17 antreibt. Dabei ist die Kette die bevorzugte Ausführungsform. Mit diesem zweiten Rad 17 ist das eine Ende des Stabventils 10 verbunden, das mit Hilfe des Schrittmotors 14 um seine Längsachse drehbar ist.

Auf der Oberseite des Ölbehälters 2 befinden sich mehrere Öffnungen, durch die Öldampf aus dem Ölbehälter 2 entweichen kann. Diese Öffnungen sind in der Fig. 1 nicht zu erkennen, sondern nur die sie umgebenden Dichtungen 18 bis 25. In dem Stabventil 10 sind mehrere Durchbohrungen 26 bis 34 vorgesehen, deren Zahl der Zahl der Dichtungen 18 bis 25 entspricht. Auf der nicht erkennbaren Gegenseite besitzt das Stabventil 10 ebenfalls Durchbohrungen, sofern es ein Hohlrohr ist. Ist es massiv ausgeführt, gehen die Durchbohrungen 26 bis 34 durch das ganze Stabventil 10.

Die gleiche Anzahl von Bohrungen 35 bis 47 befindet sich oberhalb der Längsbohrung 6 in der Ventilplatte 4. Eine entsprechende Anzahl von Bohrungen ist auch unterhalb der Längsbohrung 6 vorgesehen. Diese Bohrungen sind in der Fig. 1 jedoch nicht zu erkennen.

Wird das Öl in dem Ölbehälter 2 mittels des Heizstabs 3 aufgeheizt, gelangt es durch die Öffnungen im Ölbehälter durch in der Fig. 1 nicht dargestellte Öffnungen auf der Unterseite der Ventilplatte 4 auf das in der Längsbohrung 6 befindliche Stabventil 10. Sind die Durchbohrungen 26 bis 34 des Stabventils 10 vertikal ausgerichtet, kann verdampftes Material durch das Stabventil 10 und die entsprechenden Bohrungen 35 bis 47 durch einen durch die Feineinstellungsplatte 12 und die Düsenplatte 11 gebildeten Spalt austreten und sich auf einem über diesem Spalt befindlichen Substrat niederschlagen.

Mit 48 bis 54 sind Verbindungsbolzen bezeichnet, mit denen die Einzelteile der Ver dampfervorrichtung 1 zusammengehalten werden.

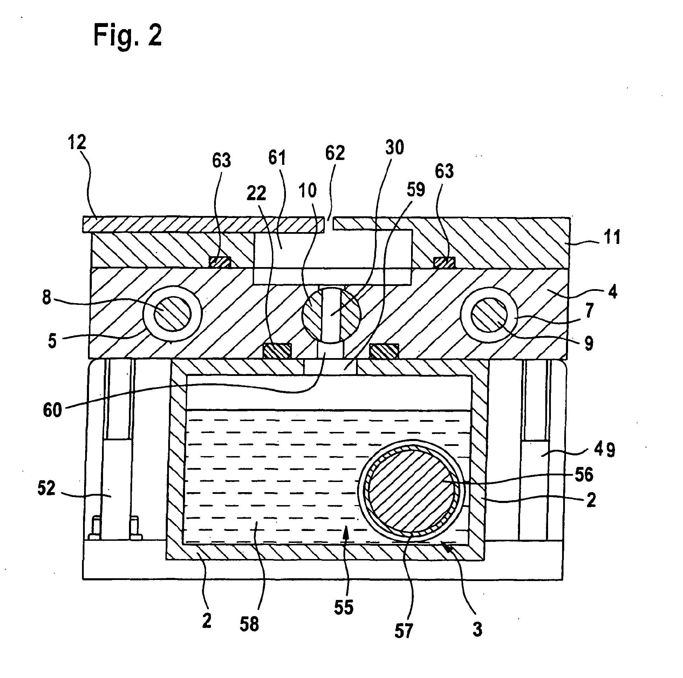

Die Fig. 2 zeigt einen Querschnitt durch die Verdampfervorrichtung 1. Im Innenraum 55 des Ölbehälters 2 befindet sich der Heizstab 3, der aus einem Kern 56 und einer Ummantelung 57 besteht. Dieser Kern 56 kann mittels einer Spannungsquelle erwärmt werden. Der Heizstab 3 ist vollständig von Öl 58 umgeben. Der Ölbehälter 2 weist auf seiner Oberseite mehrere Öffnungen auf, von denen man eine Öffnung 59 erkennt. Oberhalb dieser Öffnung 59 befindet sich eine der ringförmigen Dichtungen 18 bis 25, beispielsweise die Dichtung 22. An die Öffnung 59 schließt eine Bohrung 60 in der Ventilplatte 4 an, die ihrerseits zu der Bohrung 30 im Stabventil 10 führt. Oberhalb dieses Stabventils befindet sich ein Zwischenraum 61, der eine obere Spaltöffnung 62 aufweist. Diese Spaltöffnung 62 wird durch die Düsenplatte 11 und die Feineinstellungsplatte 12 gebildet. Zwischen der Düsenplatte 11 und der Ventilplatte 4 ist eine Dichtung 63 vorgesehen, die - wie man aus Fig. 1 erkennt - um den ganzen Zwischenraum 61 gelegt ist. In den Längsbohrungen 5, 7 erkennt man wieder die Heizstäbe 8, 9. Diese Heizstäbe 8, 9 heizen die Ventilplatte 4 auf eine Temperatur, bei der ein Kondensieren des Öls in der Ventilplatte 4 unmöglich ist.

In der Darstellung der Fig. 2 ist das Stabventil 10 offen, d. h. das verdampfte Material kann durch die Spaltöffnung 62 zu einem nicht dargestellten Substrat gelangen, das sich oberhalb dieser Spaltöffnung 62 befindet.

Durch Drehen des Stabventils 10 im Uhrzeiger- oder Gegenuhrzeigersinn kann der aus dem Ölbehälter 2 kommende Materialdampf mehr oder weniger gedrosselt werden. Ab einem bestimmten Winkel, spätestens jedoch nach einer Drehung um 90 Grad, wird der Materialdampf vollständig durch das Stabventil 10 abgeriegelt.

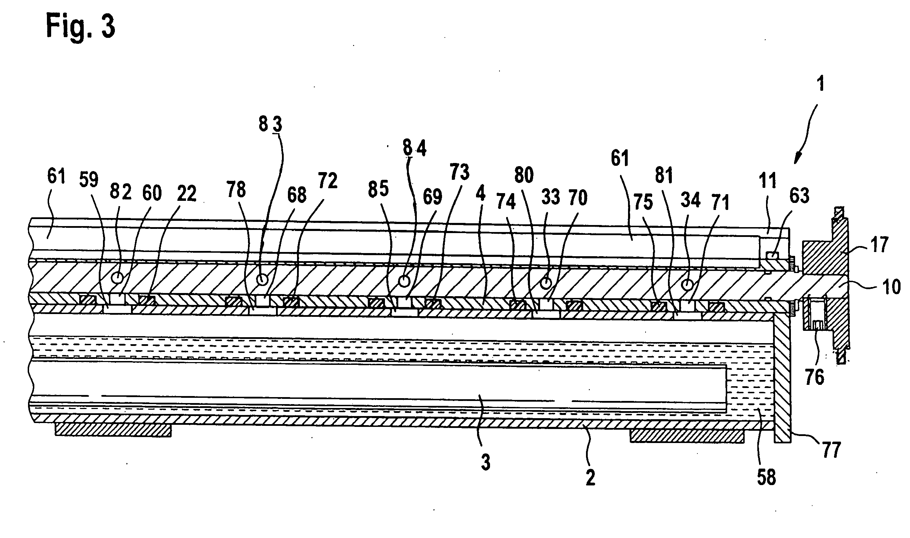

Die Fig. 3 zeigt einen Teil der in der Fig. 1 dargestellten Verdampfervorrichtung 1, und zwar bei geschlossenem Stabventil 10. Man erkennt hierbei wieder den Ölbehälter 2 mit dem Heizstab 3. Die Durchbohrungen 32 bis 34, 82 bis 84 im Stabventil 10 gehen hierbei in die Zeichenebene hinein, sodass die Öffnungen 60, 68 bis 71 auf der Unterseite der Ventilplatte 4 verschlossen sind. Es kann somit kein Öldampf aus dem Ölbehälter 2 über die Löcher 59, 78 bis 81, 85 bzw. 60, 68 bis 71 in den Zwischenraum 61 und von dort zum Substrat gelangen. Um die Öffnungen 60, 68 bis 71 herum sind die Ringdichtungen 22, 72 bis 75 angeordnet. Ferner ist eine Feststellschraube 76 zu erkennen. Über diese Feststellschraube 76, die beispielsweise eine Madenschraube sein kann, ist das Rad 17 auf der Achse des Stabventils 10 befestigt. Außerdem sieht man, dass der Ölbehälter 2 durch eine Platte 77 abgeschlossen ist. Des Weiteren ist in Fig. 3 das Rad 17 erkennbar, auf das die bevorzugte Ausführungsform des Kopplungselements 16, die Kette, aufgebracht werden kann.

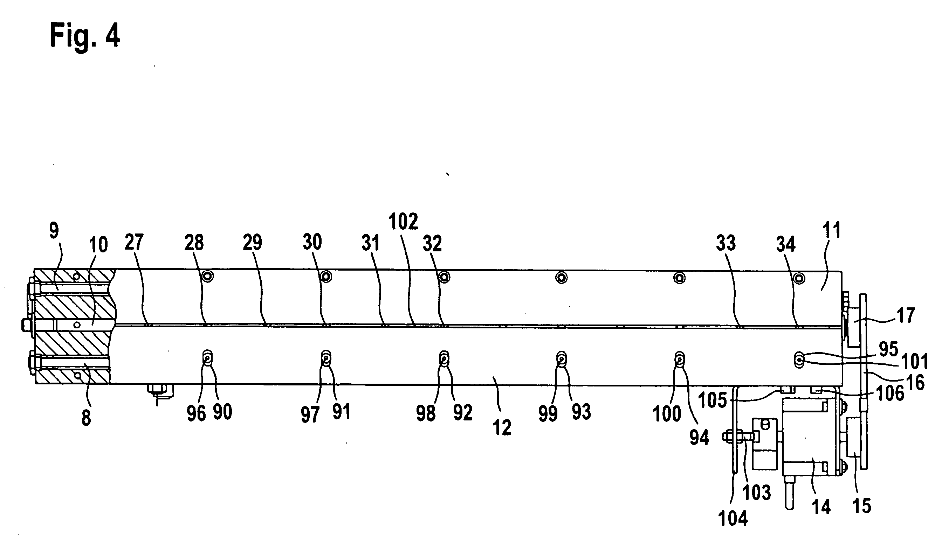

Die Fig. 4 zeigt eine teilweise aufgebrochene Draufsicht auf die Verdampfervorrichtung 1 gemäß Fig. 1. Man erkennt hierbei wieder die Düsenplatte 11 mit der Feineinstellungsplatte 12 sowie die Heizstäbe 8, 9 und das Stabventil 10. Auch die Räder 15 und 17, der Keilriemen 16 und der Schrittmotor 14 sind zu erkennen.

Die Feineinstellungsplatte 12 weist mehrere Langlöcher 90 bis 95 auf, durch die Schrauben 96 bis 101 geführt sind. Hierdurch ist es möglich, die Feineinstellungsplatte 12 so zu verschieben, dass ein zwischen ihr und der Düsenplatte 11 gebildeter Spalt größer oder kleiner wird. Durch diesen Spalt 102 kann dann der Dampf aus dem Raum 61 gelangen. Unter diesem Raum 61 sind die Öffnungen 27 bis 34 des Stabventils 10 zu erkennen.

Der Schrittmotor 14 ist über einen Bolzen 103 an einem U-förmigen Blech 104 befestigt, wobei dieses Blech 104 seinerseits mittels Schrauben 105, 106 mit der in der Fig. 4 nicht sichtbaren Ventilplatte 4 verbunden ist.

## Patentansprüche

1. Verdampfervorrichtung, enthaltend
1.1 einen Behälter (2) für die Aufnahme von zu verdampfendem Material
1.2 mit einer ersten Platte (11) Ober dem Behälter (2)
1.3 und einer zweiten Platte (12) über dem Behälter (2),
1.4 wobei die Platten (11, 12) relativ zueinander bewegbar sind und einen variablen Schlitz (62) zwischen sich bilden,
1.5 eine Ventilplatte (4), die einerseits zwischen den beiden Platten (11, 12) und andererseits dem Behälter (2) angeordnet ist,
1.6 wobei die Ventilplatte (4) einen um eine Achse drehbaren zylindrischen Körper (10) mit einer Durchbohrung (30) aufweist,
1.7 einen Zwischenraum (61) zwischen den Platten (11, 12) und der Ventilplatte (4).

2. Verdampfervorrichtung nach Anspruch 1, **dadurch gekennzeichnet, dass** auf der Oberseite des Behälters (2) für die Aufnahme von zu verdampfendem Material mehrere Öffnungen (59, 60) vorgesehen sind und der drehbare zylindrische Körper (10) ein Stabventil ist, das ebenso viele Bohrungen (30) wie der Behälter (2) Öffnungen (59, 60) aufweist.

3. Verdampfervorrichtung nach Anspruch 1, **dadurch gekennzeichnet, dass** der drehbare zylindrische Körper (10) in der Ventilplatte (4) angeordnet ist.

4. Verdampfervorrichtung nach den Ansprüchen 1 oder 3, **dadurch gekennzeichnet, dass** in der Ventilplatte (4) Heizstäbe (8, 9) vorgesehen sind.

5. Verdampfervorrichtung nach den Ansprüchen 1 oder 3, **dadurch gekennzeichnet, dass** die Ventilplatte (4) auf der Oberseite des Behälters (2) aufliegt und auf ihrer Unterseite mit einer Dichtung (22) versehen ist, die um die Öffnung (59) des Behälters (2) verläuft.

6. Verdampfervorrichtung nach Anspruch 1, **dadurch gekennzeichnet, dass** der drehbare zylindrische Körper (10) mittels eines Motors (14) drehbar ist.

7. Verdampfervorrichtung nach Anspruch 6, **dadurch gekennzeichnet, dass** der Motor (14) mit einem ersten Rad (15) gekoppelt ist, das über ein Kopplungselement (16) mit einem zweiten Rad (17) gekoppelt ist.

8. Verdampfervorrichtung nach Anspruch 7, **dadurch gekennzeichnet, dass** das Kopplungselement (16) eine Kette ist.

9. Verdampfervorrichtung nach Anspruch 1, **dadurch gekennzeichnet, dass** in dem Behälter (2) für die Aufnahme von zu verdampfendem Material wenigstens ein Heizrohr (3) angeordnet ist.

10. Verdampfervorrichtung nach Anspruch 9, **dadurch gekennzeichnet, dass** das Heizrohr (3) aus einem Kern (56) und einer Ummantelung (57) besteht.

11. Verdampfervorrichtung nach Anspruch 4, **dadurch gekennzeichnet, dass** die Heizstäbe (8, 9) die Ventilplatte auf einer Temperatur halten, die oberhalb des Siedepunkts des Öls (58) liegt.

## Claims

1. Evaporator device comprising:
1.1 a receptacle (2) for holding material to be evaporated
1.2 with a first plate (11) above the receptacle (2)
1.3 and a second plate (12) above the receptacle (2),
1.4 the plates (11, 12) being movable relative to each other and establishing a variable slot (62) between them,
1.5 a valve plate (4) arranged between said both plates (11, 12) on one side and said receptacle (2) on the other side,
1.6 wherein the valve plate (4) comprises a rotatable cylindrical body (10) with a throughbore (30),
1.7 an interspace (61) between the plates (11, 12) and said valve plate (4).

2. Evaporator device as claimed in claim 1, **characterized in that** on the top side of the receptacle (2) for holding material to be evaporated several openings (59, 60) are provided and the rotatable cylindrical body (10) is a rod valve which has as many bores (30) as the receptacle (2) has openings (59, 60).

3. Evaporator device as claimed in claim 1, **characterized in that** the rotatable cylindrical body (10) is disposed in the valve plate (4).

4. Evaporator device as claimed in claims 1 or 3, **characterized in that** heating rods (8, 9) are provided in the valve plate (4).

5. Evaporator device as claimed in claims 1 or 3, **characterized in that** the valve plate (4) rests on the top side of the receptacle (2) and on its underside is provided with a seal (22), which extends about the opening of the receptacle (2).

6. Evaporator device as claimed in claim 1, **characterized in that** the rotatable cylindrical body (10) is rotatable with a motor (14).

7. Evaporator device as claimed in claim 6, **characterized in that** the motor (14) is coupled with a first wheel (15), which is coupled via a coupling element (16) with a second wheel (17).

8. Evaporator device as claimed in claim 7, **characterized in that** the coupling element (16) is a chain.

9. Evaporator device as claimed in claim 1, **characterized in that** in the receptacle (2) for holding material to be evaporated at least one heating tube (3) is disposed.

10. Evaporator device as claimed in claim 9, **characterized in that** the heating tube (3) is comprised of a core (56) and a casing (57).

11. Evaporator device as claimed in claim 4, **characterized in that** the heating rods (8, 9) maintain the valve plate at a temperature above the boiling point of the oil (58).

## Revendications

1. Evaporateur comprenant
1.1 un réservoir (2) destiné à recevoir un matériau à évaporer
1.2 avec une première plaque (11) située au-dessus du réservoir (2)
1.3 et une deuxième plaque (12) située au-dessus du réservoir (2),
1.4 les plaques (11, 12) pouvant bouger l'une par rapport à l'autre et formant entre elles une fente variable (62),
1.5 une plaque porte-soupape (4) qui est disposée entre, d'un côté, les deux plaques (11, 12) et, de l'autre côté, le réservoir (2),
1.6 la plaque porte-soupape (4) présentant un corps cylindrique (10) pouvant tourner autour d'un axe et pourvu d'une perforation (30),
1.7 un espace intermédiaire (61) situé entre les plaques (11, 12) et la plaque porte-soupape (4).

2. Evaporateur selon la revendication 1, **caractérisé en ce que** plusieurs ouvertures (59, 60) sont prévues sur la face supérieure du réservoir (2) destiné à recevoir un matériau à évaporer, et **en ce que** le corps cylindrique rotatif (10) est une soupape en tige qui présente autant de trous (30) que le réservoir (2) présente d'ouvertes (59, 60).

3. Evaporateur selon la revendication 1, **caractérisé en ce que** le corps cylindrique rotatif (10) est disposé dans la plaque porte-soupape (4).

4. Evaporateur selon la revendication 1 ou 3, **caractérisé en ce que** des tiges chauffantes (8, 9) sont prévues dans la plaque porte-soupape (4).

5. Evaporateur selon la revendication 1 ou 3, **caractérisé en ce que** la plaque porte-soupape (4) repose sur la face supérieure du réservoir (2) et est pourvue, sur sa face inférieure, d'un joint d'étanchéité (22) qui entoure l'ouverture (59) du réservoir (2).

6. Evaporateur selon la revendication 1, **caractérisé en ce que** le corps cylindrique rotatif (10) peut tourner au moyen d'un moteur (14).

7. Evaporateur selon la revendication 6, **caractérisé en ce que** le moteur (14) est couplé à une première roue (15), laquelle est couplée, par le biais d'un élément de couplage (16), à une deuxième roue (17).

8. Evaporateur selon la revendication 7, **caractérisé en ce que** l'élément de couplage (16) est une chaîne.

9. Evaporateur selon la revendication 1, **caractérisé en ce qu'**au moins un tube chauffant (3) est disposé dans le réservoir (2) destiné à recevoir un matériau à évaporer.

10. Evaporateur selon la revendication 9, **caractérisé en ce que** le tube chauffant (3) se compose d'un noyau (56) et d'une enveloppe (57).

11. Evaporateur selon la revendication 4, **caractérisé en ce que** les tiges chauffantes (8, 9) maintiennent la plaque porte-soupape à une température située au-dessus du point d'ébullition de l'huile (58).
